# EUROPÄISCHE PATENTSCHRIFT

(11) **EP 3 055 447 B1**
(45) Veröffentlichungstag und Bekanntmachung des Hinweises auf die Patenterteilung: **13.03.2024**
(21) Anmeldenummer: 14781229.1
(22) Anmeldetag: 08.10.2014
(51) Int. Cl.: C30B 33/06, B23K 26/40, B28D 1/22, H01L 21/762, B28D 1/00, B28D 5/00, B23K 26/53, B23K 103/00

(54) **ERZEUGUNG EINER RISSAUSLÖSESTELLE ODER EINER RISSFÜHRUNG ZUM VERBESSERTEN ABSPALTEN EINER FESTKÖRPERSCHICHT VON EINEM FESTKÖRPER**
CREATION OF A CRACK-INITIATING POINT OR A CRACKING LINE FOR THE IMPROVED SPLITTING OFF OF A SOLID LAYER FROM A SOLID BODY
CRÉATION D'UN POINT DE DÉPART DE FISSURE OU D'UN GUIDE DE FISSURATION AFIN DE PERMETTRE UN MEILLEUR DÉTACHEMENT D'UNE COUCHE DE SOLIDE À PARTIR D'UN SOLIDE

(30) Priorität: 08.10.2013 DE 102013016682
(43) Veröffentlichungstag der Anmeldung: 17.08.2016
(73) Patentinhaber: Siltectra GmbH, 01099 Dresden (DE)
(72) Erfinder: DRESCHER, Wolfram, 01099 Dresden (DE); RICHTER, Jan, 01277 Dresden (DE)
(74) Vertreter: Müller Hoffmann & Partner
(86) Internationale Anmeldenummer: PCT/EP2014/071509
(87) Internationale Veröffentlichungsnummer: WO 2015/052218

(56) Entgegenhaltungen:
- EP-A1- 0 533 551
- WO-A1-2014/177721
- WO-A2-2007/087354
- WO-A2-2008/082723
- WO-A2-2009/061353
- WO-A2-2013/126927
- US-A1- 2007 249 140

## Beschreibung

Die vorliegende Erfindung bezieht sich auf ein Verfahren zum Herstellen von Festkörperschichten gemäß dem Gegenstand von Anspruch 1.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafer für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 (WO 2009 / 061 353 A2) und PCT/EP2009/067539 beschrieben sind, wo zum Erzeugen dieser Spannungen eine auf das Werkstück aufgetragene Polymerschicht verwendet wird.

Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hoher Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Beim Abspalten eines Wafers vom Werkstück haftet bei den erwähnten Verfahren jeweils auf einer Seite des Wafers noch Polymer an. Der Wafer krümmt sich dabei sehr stark in Richtung dieser Polymerschicht, was ein kontrolliertes Abspalten erschwert, und z.B. zu Dickenschwankungen des abgespaltenen Wafers führen kann. Außerdem erschwert die starke Krümmung die weitere Verarbeitung und kann sogar zum Zerbrechen des Wafers führen.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vierzähliger Symmetrie zeigt. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet. Außerdem liegen bei den am häufigsten auftretenden vierzähligen Dickenverteilungsmustern die Bereiche mit den größten Schwankungen unglücklicherweise in der Mitte des Wafers, wo sie am meisten stören.

Außerdem entstehen beim Verfahren nach aktuellem Stand der Technik während der Bruchpropagation beim Abspalten selbst unerwünschte Oszillationen in den beteiligten Schichtsystemen, die den Verlauf der Bruchfront ungünstig beeinflussen und insbesondere zu signifikanten Dickenschwankungen des abgespaltenen Wafers führen können.

Zudem ist es bei den bisherigen Verfahren schwierig, einen reproduzierbar guten Wärmekontakt über die ganze Fläche der Polymerschicht sicherzustellen. Lokal ungenügender Wärmekontakt kann aber aufgrund der geringen thermischen Leitfähigkeit der verwendeten Polymere zu ungewollten, signifikanten lokalen Temperaturabweichungen im Schichtsystem führen, was sich seinerseits negativ auf die Kontrollierbarkeit der erzeugten Spannungsfelder und damit die Qualität der hergestellten Wafer auswirkt.

Ein alternatives Verfahren, das ebenfalls ohne Sägen auskommt, wird durch die Druckschrift DE 692 31 328 T2 (EP 0 533 551 A1) beschrieben. Gemäß dieser Druckschrift werden mittels einer Ionenimplantation H⁺-Ionen mit 150 keV in eine monokristalline Siliciumplatte eingebracht. Die H⁺-Ionen werden dabei derart gesteuert in die Siliciumplatte eingebracht, dass sie im Wesentlichen auf einer definierten Ebene innerhalb der Platte zum Liegen kommen. Die Dosis der dabei implantierten H⁺-Ionen ist dabei größer als 10¹⁶cm⁻², wodurch infolge einer Erhitzung der Siliciumplatte auf eine Temperatur von größer 500°C eine Koaleszenz der eingebrachten Ionen bewirkt wird, was zu einer Abtrennung der die Ebene der eingebrachten Ionen benachbarenden Anteile der Siliciumplatte führt.

Dieses Verfahren ist sehr kostenintensiv und komplex, da eine äußerst aufwendige und kostenintensive lonenkanone mit entsprechenden Steuereinrichtungen bereitgestellt werden muss. Weiterhin dauert die Implantation der Ionen aufgrund der hohen Dosis recht lange. Ferner erfordert das Aufheizen der Siliciumplatte eine hohe Energieaufbringung und verhindert, dass elektrische Bauteile, die bei so hohen Temperaturen beschädigt werden, vor dem Erhitzen an der Siliciumplatte angeordnet werden können.

Weiterhin ist aus der Druckschrift DE112006002738A5 ein Verfahren zum Vereinzeln eines Wafers bzw. ein Verfahren zum Durchtrennen von sprödem Flachmaterial z.B. aus Glas, Keramik oder Saphir, bei dem mittels Laser das Material entlang gewünschter Trennlinien bis unter die Schmelztemperatur erwärmt wird und durch einen nachgeführten Kühlmittelstrahl abgeschreckt wird, sodass eine thermische Spannungsdifferenz induziert wird die eine Material Durchtrennung bewirkt, wobei im Voraus entlang der Trennlinien Kerben in das Flachmaterial eingebracht werden und der Laser in die Kerbspitzen gerichtet wird, bekannt. Dieses Verfahren dient somit zum Vereinzeln der einen Wafer bildenden Computerchips entlang sogenannter Scribe-Lines.

Die WO 2013 / 126 927 A2 beschreibt das Delaminieren (Abspalten) einer Bauteilschicht von einem Spendersubstrat. Ein Laserschritt bildet in einer horizontalen ersten Zone des Spendersubstrats Hohlräume und in einer zweiten horizontalen Zone des Spendersubstrats Polysiliziumzonen. In der ersten Zone steht das Spendersubstrat unter Zugspannung. In der benachbarten zweiten Zone steht das Spendersubstrat unter Druckspannung. Ein Delaminierungsprozess spaltet die Bauteilschicht entlang einer Laserspaltfläche, die zwischen der ersten Zone und der zweiten Zone verläuft, vom Spendersubstrat ab. Der Delaminierungsprozess umfasst eine thermische Behandlung, die eine mechanische Spannung in das Spendersubstrat induziert, wobei während der thermischen Behandlung das Spendersubstrat durch eine Substrathalterung und/oder einen Waferhandler fixiert ist.

Die thermische Behandlung kann eine Erwärmung und/oder Abkühlung des Spendersubstrats umfassen, wobei zum Beispiel ein Strahl mit flüssigem Stickstoff auf die Oberfläche des Spendersubstrats gerichtet wird. Insbesondere erhöht die thermische Behandlung die intrinsische mechanische Spannung im Spendersubstrat und unterstützt so die Rissausbreitung entlang der Laserspaltfläche. Die thermische Behandlung verstärkt den mechanischen Stress zwischen den durch die vorangegangene Laserbestrahlung modifizierten Teilen des Spendersubstrats und den unmodifizierten Teilen des Spendersubstrats und nutzt damit eine intrinsische CTE Fehlanpassung zwischen der Zone mit polykristallinem Material und der Zone mit Hohlräumen.

Die Druckschrift WO 2007 / 087 354 A2 beschreibt das horizontale Spalten eines Silizium-Ingots ausgehend von einer Kerbe am Rand des Ingots. Ein Laserstrahl wird im Abstand von der planaren Oberfläche des Ingots zunächst nahe der Spitze der Kerbe und später in zunehmenden horizontalen Abstand zur Kerbe fokussiert. Der Laserstrahl erhitzt lokal den Siliziumkristall. Die dadurch induzierten thermomechanischen Spannungen sorgen für die horizontale Ausbreitung des Risses in das Innere des Ingots bis zur endgültigen Ablösung einer Scheibe vom Silizium-Ingot. Die kristalline Struktur des Siliziums bleibt erhalten.

Die Druckschrift US 2007 / 0 249 140 A1 bezieht sich auf die Herstellung von Solarzellen aus kristallinem Siliziummaterial. Ein stressinduzierendes Material wird auf die Oberfläche eines Muttersubstrats aufgebracht. Eine untere Teilschicht des stressinduzierenden Materials enthält beispielsweise Silber und eine obere Teilschicht Aluminium. Beim Erhitzen zieht die stressinduzierende Schicht eine dünne Teilschicht des Muttersubstrats ab. Die Druckschrift WO 2008 / 082 723 A2 bezieht sich ebenfalls auf das Herstellen von Solarzellen aus kristallinem Siliziummaterial. Mittels eines Lasers wird entlang einer Spaltebene eines Ausgangssubstrats thermische Energie eingetragen. Der Temperaturgradient zwischen stark erwärmtem Silizium und weniger stark erwärmtem Silizium induziert mechanischen Stress (fracture stress), der entlang der Spaltebene geführt wird.

Es ist somit die Aufgabe der vorliegenden Erfindung ein Verfahren zur Herstellung von Festkörperschichten bereitzustellen, das die kostengünstige Herstellung von Festkörperplatten bzw. Wafern mit einer gleichmäßigen Dicke ermöglicht, insbesondere mit einem TTV von weniger als 120 Mikrometer.

Weitere vorteilhafte Ausführungsformen sind Gegenstand der nachfolgenden Beschreibung und/oder der Unteransprüche.

Die vorliegende Erfindung bezieht sich auf ein Verfahren zum Herstellen von Festkörperschichten gemäß Anspruch 1. Das erfindungsgemäße Verfahren zum Herstellen von Festkörperschichten umfasst dabei mindestens die Schritte: Bereitstellen eines Festkörpers zum Abtrennen mindestens einer Festkörperschicht, Erzeugen von Defekten mittels mindestens einer Strahlungsquelle, insbesondere einem Laser, in der inneren Struktur des Festkörpers zum Vorgeben einer Rissauslösestelle, ausgehend von der die Festkörperschicht vom Festkörper abgetrennt wird und/oder Erzeugen von Defekten mittels mindestens der Strahlungsquelle, insbesondere einem Laser, in der inneren Struktur des Festkörpers zum Vorgeben einer Rissführung, entlang der die Festkörperschicht vom Festkörper abgetrennt wird, Anordnen einer Aufnahmeschicht zum Halten der Festkörperschicht an dem Festkörper, thermisches Beaufschlagen der Aufnahmeschicht zum, insbesondere mechanischen, Erzeugen von Spannungen in dem Festkörper, wobei sich durch die Spannungen ein Riss ausgehend von der Rissauslösestelle und/oder entlang der Rissführung in dem Festkörper ausbreitet, der die Festkörperschicht von dem Festkörper abtrennt. Diese Lösung ist vorteilhaft, da der Rissverlauf deutlich verbessert vorgegeben werden kann, wodurch deutlich ebenere Festkörperschichten bzw. Festkörperschichten mit einem deutlich geringeren TTV erzeugt werden können.

Es wird beispielsweise eine auf die Waferoberfläche gerichtete Laserstrahlung, z.B. eines UV-Lasers, relativ zum Wafer lokal zum Erzeugen der Rissauslösestelle aufgebracht und/oder in der Umfangsrichtung des Festkörpers zum Erzeugen der Rissführung geführt. Die entstehenden Kerben haben bevorzugt eine Breite von 2-5 µm und eine Tiefe von bevorzugt 3-10 µm. Die Schnittgeschwindigkeit liegt bevorzugt im Bereich von 50 bis 70 mm/s. Die Tiefe der Kerben kann z.B. kleiner 1/10 oder kleiner 1/100 oder kleiner 1/1000 der Materialdicke bzw. des Durchmessers des Festkörpers bzw. der Breite des Festkörpers sein. Gegenüber einem mechanischen Vorritzen ist die Verfahrensgeschwindigkeit deutlich höher.

Nach der Erzeugung der Kerbe bzw. der Erzeugung der Defekte werden im Bereich der Defekte bzw. der Kerbe thermisch induzierte Spannungsdifferenzen erzeugt, die einen oder mehrere von den Spitzen der Kerbe ausgehend das Flachmaterial durchtrennende Trennrisse bewirkt. Die thermische Spannungsdifferenz wird induziert indem z.B. eine zweite Laserstrahlung, z.B. eines CO2 -Lasers über die Kerbe bzw. den Bereich der Defekte geführt wird (thermische Druckspannung), der ein Kühlmittelstrahl folgt (thermische Zugspannung). Durch die zweite Laserstrahlung, wird das Material in der Kerbe bzw. das Material im Bereich der Defekte bis kurz unter die Schmelztemperatur aufgeheizt und durch den folgenden Kühlmittelstrahl aus einem Wasser-Luftgemisch (Aerosol) oder einem gekühlten Gas abgeschreckt. Dieser Vorgang passiert bevorzugt mit einer Geschwindigkeit von 300 bis 400 mm/s.

Die Auswahl der Laser für die erste und zweite Laserstrahlung sowie deren Prozessparameter, erfolgt materialabhängig. Während der Laser für die erste Laserstrahlung und die hierbei wirkenden Verfahrensparameter (insbesondere Laserleistung, Pulsregime und die Geschwindigkeit der Relativbewegung) bevorzugt so ausgewählt wird, dass das Material im beaufschlagten Bereich schmilzt und ausgetrieben wird, wird der Laser für die zweite Laserstrahlung und die hier wirkenden Verfahrensparameter bevorzugt so gewählt, dass das Material nur bis annähernd an die Schmelztemperatur erwärmt wird.

Es können sowohl unterschiedliche Laser als auch der gleiche Laser verwendet werden. Die unterschiedliche Erwärmung kann bewirkt werden in dem Laser mit unterschiedlichen Wellenlängen verwendet werden die vom Material unterschiedlich stark absorbiert werden. Oder aber die Strahlgeometrie des auf die Oberfläche auftreffenden Strahlungsflecks der Laserstrahlung bzw. Strahlungsdichteverteilung im Strahlungsfleck kann zur Erzeugung der beiden unterschiedlich wirkenden Laserstrahlungen verändert werden. Auch eine Variation der Laserleistung oder des Pulsregimes können den gewünschten Effekt bewirken.

Für den Fall der Erzeugung einer Kerbe ist die Erfindung ist nicht daran gebunden, dass die Kerbe mittels Laser erzeugt wird. Eine Erzeugung der Kerbe mittels Laser ist jedoch von Vorteil um das Durchtrennen mit nur einer Technologie durchzuführen. Die positiven Effekte der Erfindung die im Wesentlichen dadurch bewirkt werden, dass bei einem erfindungsgemäßen Verfahren anstelle eines notwendigen Initialrisses an jeder Startkante, der durch ein Anritzen erfolgt, eine Kerbe bzw. eine mittels Defekten bewirkte Materialschwächung im Bereich der gewünschten Rissauslösestelle oder entlang der gesamten gewünschten Trennlinie bzw. Rissausbreitungslinie erzeugt wird. So könnte die Kerbe z.B. auch mechanisch oder durch Ätzen erzeugt werden.

Grundsätzlich ist die Art der Herstellung der Kerbe nicht entscheidend, sondern vielmehr die Tatsache, dass eine solche Kerbe bzw. Materialschwächung bzw. Festigkeitsschwächung im Bereich der Rissauslösestelle bzw. entlang einer Rissführung eingebracht bzw. erzeugt wird, um entweder von den Spitzen der Kerbe ausgehend, einen Anriss des Festkörpers zu bewirken oder durch die Materialschwächung bzw. Festigkeitsreduzierung einen definierten Ort bzw. Bereich zu schaffen, der angerissen wird bzw. in dem ein Riss im Festkörper beginnt und/oder sich definiert ausbreitet. Somit ist denkbar, dass die Defekte nicht zur Erzeugung einer Kerbe, sondern zum Bewirken einer lokalen Materialschwächung erzeugt werden. So kann zum Beispiel durch Energieeintrag das Materialgefüge verändert werden oder durch Ionenimplantation das Material örtlich gezielt dotiert werden, um die Materialeigenschaften so zu verändern, dass die kritische Bruchspannung in der Rissauslösestelle und/oder entlang der Rissführung verringert wird.

Gemäß einer bevorzugten Ausführungsform der vorliegenden Erfindung werden die Bereiche des Festkörpers, in denen die Defekte erzeugt wurden, derart thermisch beaufschlagt, dass sich lokale Druckspannungen ergeben, wobei nach der Erzeugung der Druckspannungen eine weitere thermische Beaufschlagung zum Erzeugen von lokalen Zugspannungen erfolgt, wobei sich durch die unterschiedlichen thermischen Beaufschlagungen der Festkörper im Bereich der Defekte einreist. Diese Ausführungsform ist vorteilhaft, da bereits ein Teilriss des Festkörpers bewirkt wurde, dessen Genauigkeit bzw. Ebenheit äußerst hoch ist. Bevorzugt werden die Defekte zur Vorgabe der Rissführung teilweise und bevorzugt vollständig in Umfangsrichtung des Festkörpers eingebracht. Es ist hierbei denkbar, dass in dem Festkörper in Umfangsrichtung der Ablöseebene auf mehr, genau oder weniger als 10, 20, 30, 40, 50, 60, 70, 80 oder 90 Prozent des Umfangs Defekte erzeugt werden.

Der Festkörper wird gemäß einer weiteren bevorzugten Ausführungsform der vorliegenden Erfindung zum Erzeugen der Druckspannungen im Bereich der Defekte mittels eines Lasers erwärmt und wird zum Erzeugen der Zugspannungen mittels eines Kühlmittelstrahls abgekühlt. Diese Ausführungsform ist vorteilhaft, da aufgrund der thermischen Effekte innerhalb des Festkörpers kontrolliert das Anreisen des Festkörpers bewirkbar ist.

Die Spannungen zum Ablösen der Festkörperschicht werden durch die thermische Beaufschlagung der Aufnahmeschicht, also einer Polymerschicht, erzeugt. Die thermische Beaufschlagung stellt ein Abkühlen der Aufnahmeschicht bzw. Polymerschicht auf oder unter 10°C und besonders bevorzugt unter 0°C und weiter bevorzugt unter -10°C dar. Die Abkühlung der Polymerschicht erfolgt höchst bevorzugt derart, dass zumindest ein Teil der Polymerschicht, die bevorzugt aus PDMS besteht, einen Glasübergang vollzieht. Die Abkühlung kann hierbei eine Abkühlung auf unter -100°C sein, die z.B. mittels flüssigen Stickstoffs bewirkbar ist. Die Polymerschicht zieht sich in Abhängigkeit von der Temperaturveränderung zusammen und/oder erfährt einen Glasübergang und überträgt die dabei entstehenden Kräfte auf den Festkörper, wodurch mechanische Spannungen in dem Festkörper erzeugbar sind, die zum Auslösen eines Risses und/oder zur Rissausbreitung führen, wobei sich der Riss zunächst entlang der ersten Ablöseebene zum Abspalten der Festkörperschicht ausbreitet.

Gemäß einer bevorzugten Ausführungsform der vorliegenden Erfindung wird der Festkörper an einer Halteschicht zum Halten des Festkörpers angeordnet, wobei die Halteschicht an einem ersten ebenen Flächenanteil des Festkörpers angeordnet wird, wobei der erste ebene Flächenanteil des Festkörpers von einem zweiten ebenen Flächenanteil des Festkörpers beabstandet ist, wobei am zweiten ebenen Flächenanteil die Polymerschicht angeordnet ist und wobei die Ablöseebene gegenüber dem ersten ebenen Flächenanteil und/oder dem zweiten ebenen Flächenanteil parallel ausgerichtet wird bzw. parallel erzeugt wird.

Diese Ausführungsform ist vorteilhaft, da der Festkörper zumindest abschnittweise und bevorzugt vollständig zwischen der Halteschicht und der Polymerschicht angeordnet ist, wodurch mittels einer dieser Schichten oder mittels beider Schichten die Spannungen zur Risserzeugung bzw. Rissausbreitung in den Festkörper einleitbar sind.

Mindestens oder genau eine Strahlungsquelle ist gemäß einer weiteren bevorzugten Ausführungsform der vorliegenden Erfindung zum Bereitstellen der in den Festkörper einzubringenden Strahlung derart konfiguriert, dass die von ihr ausgestrahlten Strahlen die Defekte an vorbestimmten Orten innerhalb des Festkörpers erzeugen. Diese Ausführungsform ist vorteilhaft, da mittels einer Strahlungsquelle, insbesondere mittels eines Lasers, äußerst genau Defekte in dem Festkörper erzeugbar sind.

Der Festkörper weist gemäß einer weiteren bevorzugten Ausführungsform der vorliegenden Erfindung Silizium und/oder Gallium oder Perowskit auf und die Polymerschicht und/oder die Halteschicht bestehen zumindest teilweise und bevorzugt vollständig oder zu mehr als 75% aus Polydimethylsiloxane (PDMS), wobei die Halteschicht an einer zumindest abschnittsweise ebenen Fläche einer Stabilisierungseinrichtung angeordnet ist, die zumindest teilweise aus mindestens einem Metall besteht. Die Stabilisierungseinrichtung ist bevorzugt eine Platte, insbesondere eine Platte die Aluminium aufweist oder daraus besteht. Diese Ausführungsform ist vorteilhaft, da durch die Stabilisierungseinrichtung und die Halteschicht der Festkörper definiert bzw. fest gehalten wird, wodurch die Spannungen sehr genau in dem Festkörper erzeugt werden können.

Gemäß einer weiteren bevorzugten Ausführungsform der vorliegenden Erfindung sind die Spannungen in dem Festkörper derart einstellbar bzw. erzeugbar, dass die Rissauslösung und/oder die Rissausbreitung zum Erzeugen einer Topografie der sich in der Rissebene ergebenden Oberfläche steuerbar ist/sind. Die Spannungen sind somit bevorzugt in unterschiedlichen Bereichen des Festkörpers bevorzugt zumindest zeitweise unterschiedlich stark erzeugbar. Diese Ausführungsform ist vorteilhaft, da durch Steuerung der Rissauslösung und/oder des Rissverlaufs die Topographie der erzeugten bzw. abgetrennten Festkörperschicht vorteilhaft beeinflussbar ist.

Der Festkörper weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAISb, Hochtemperatursupraleiter, insbesondere seltene Erden Cuprate (z.B. YBa2Cu3O7).

Gemäß einer weiteren bevorzugten Ausführungsform der vorliegenden Erfindung werden die Defekte zur Erzeugung der Rissauslösestelle und/oder zur Erzeugung der Rissführung und/oder zum Definieren bzw. Festlegen einer Ablöseebene durch die Einbringung von Ionen in den Festkörper bewirkt, wobei die Ionen mittels der Strahlungsquelle bereitgestellt werden.

Mindestens oder genau eine Strahlungsquelle ist gemäß einer weiteren bevorzugten Ausführungsform der vorliegenden Erfindung zum Bereitstellen der in den Festkörper einzubringenden Ionen vorgesehen, wobei die Strahlungsquelle derart ausgerichtet ist, dass die von ihr ausgestrahlten Ionen in den Festkörper eindringen. Die Strahlungsquelle dient bevorzugt zur Bereitstellung von H⁺-Ionen oder von Edelgasionen, wie z.B. der Stoffe Neon, Krypton und Xenon, wobei die Ionen der verbleibenden nichtgenannten Edelgase ebenfalls Einsatz finden können. Weiterhin ist denkbar, dass die Ionen der zuvor genannten Stoffe und/oder weiterer Stoffe getrennt oder kombiniert eingesetzt werden.

Die Strahlungsquelle wird gemäß einer weiteren bevorzugten Ausführungsform der vorliegenden Erfindung derart eingestellt, dass die von ihr ausgestrahlten Ionen zum Erzeugen der Ablöseebene auf eine definierte Tiefe, insbesondere <100µm, in den Festkörper eindringen. Bevorzugt wird die Ablöseebene parallel beabstandet zu einer äußeren und bevorzugt ebenen Oberfläche des Festkörpers ausgebildet. Bevorzugt ist die Ablöseebene weniger als 100 Mikrometer und bevorzugt weniger als 50 Mikrometer und besonders bevorzugt weniger als oder gleich 20, 10, 5 oder 2 Mikrometer von der ebenen Oberfläche des Festkörpers beabstandet innerhalb des Festkörpers ausgebildet.

Der Festkörper wird gemäß einer weiteren bevorzugten Ausführungsform der vorliegenden Erfindung mit einer vorgegebenen Dosis an Ionen beaufschlagt, wobei die vorgegebene Dosis kleiner als 5+10¹⁵cm⁻² oder kleiner als 10¹⁵cm⁻² oder kleiner als 10¹⁴cm⁻² oder kleiner als 10¹³cm⁻² ist. Diese Ausführungsform ist vorteilhaft, da durch die geringe Dosis zwar Defekte innerhalb des Festkörpers erzeugt werden, die eine vorteilhafte Rissführung bewirken, jedoch die Implantationszeit relativ kurz ist und die einzusetzende Energie relativ gering ist.

Gemäß einer weiteren bevorzugten Ausführungsform der vorliegenden Erfindung wird der Festkörper derart temperiert, dass eine Koaleszenz der in den Festkörper eingebrachten Ionen verhindert wird. Eine Koaleszenz bezeichnet im Allgemeinen das Zusammenfließen kolloidaler Teilchen. Als Kolloide werden hierbei Teilchen bzw. Ionen bezeichnet, die im Dispersionsmedium (Festkörper) fein verteilt sind. Diese Ausführungsform ist vorteilhaft, da nicht nur temperaturstabile Festkörper, sondern auch temperaturkritische Festkörper bzw. Festkörper mit temperaturkritischen Bestandteilen, wie z.B. Elektronikbauteilen, die bei Temperaturen von größer 50°C oder größer 100°C oder größer 200°C oder größer 300°C oder größer 400°C oder größer 500°C beschädigt werden, verarbeitet werden können.

Mittels des erfindungsgemäßen Verfahrens werden somit seitlich an der Kante des Wafers ein definierter Startpunkt und/oder eine definierte Rissführung in einer gewünschten Höhe erzeugt. Das Verfahren ist dabei beliebig mit den anderen beiden Verfahren kombinierbar welche eine flächige Schichtschädigung erzeugen. Der Vorteil von dem Verfahren ist, dass es nicht nur eine Schädigung des Materials gibt, sondern einen echten Risskeim, der dann bei der Erzeugung mechanischer Spannungen durch die Abkühlung einer an dem Festkörper angebrachten Schicht als Ausgangspunkt für den Riss dient. Dies senkt die Energiebarriere für den Rissanfang dramatisch, ermöglicht einen definierten Rissstart in definierbarer Höhe (z.B. genau in Höhe der eingebrachten Schädigungsschicht) oder bei Applikation auf eine kalte Probe könnte es als Rissinitialisierung als Teil des Splitgerätes verwendet werden.

Die Erfindung bezieht sich ferner auf einen Wafer, der nach einem Verfahren gemäß einem der Ansprüche hergestellt wird.

Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder Anordnungen entsprechen bevorzugt genau oder bevorzugt im Wesentlichen denen der erfindungsgemäßen Vorrichtung bzw. des erfindungsgemäßen Produkts.

Weitere Vorteile, Ziele und Eigenschaften der vorliegenden Erfindung werden anhand nachfolgender Beschreibung anliegender Zeichnungen erläutert, in welchen beispielhaft die erfindungsgemäße Waferherstellung dargestellt ist. Bauteile oder Elemente der erfindungsgemäßen Waferherstellung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigt:
- Fig. 1a: die Erzeugung von Defekten zur Ausbildung einer Rissauslösestelle und/oder einer Rissführung;
- Fig. 1b: die Erzeugung eines Anrisses des Festkörpers infolge thermisch induzierter Spannungen;
- Fig. 1c: einen im Bereich einer Ablöseebene angerissenen Festkörper;
- Fig. 1d: den aus Fig. 1c bekannten Festkörper mit daran angeordneten Schichten;
- Fig. 1e: einen Zustand nach der Abtrennung der Festkörperschicht von dem Festkörper;
- Fig. 2a: einen schematischen Aufbau zum Erzeugen von Defekten in einem Festkörper;
- Fig. 2b: eine schematische Darstellung einer Schichtanordnung vor dem Abtrennen einer Festkörperschicht von einem Festkörper;
- Fig. 2c: eine schematische Darstellung einer Schichtanordnung nach dem Abtrennen einer Festkörperschicht von einem Festkörper;
- Fig. 3a: eine erste schematisch dargestellte Variante zur Defekterzeugung mittels Lichtwellen;
- Fig. 3b: eine zweite schematisch dargestellte Variante zur Defekterzeugung mittels Lichtwellen; und
- Fig. 4: eine schematische Darstellung der Ablöseebene.

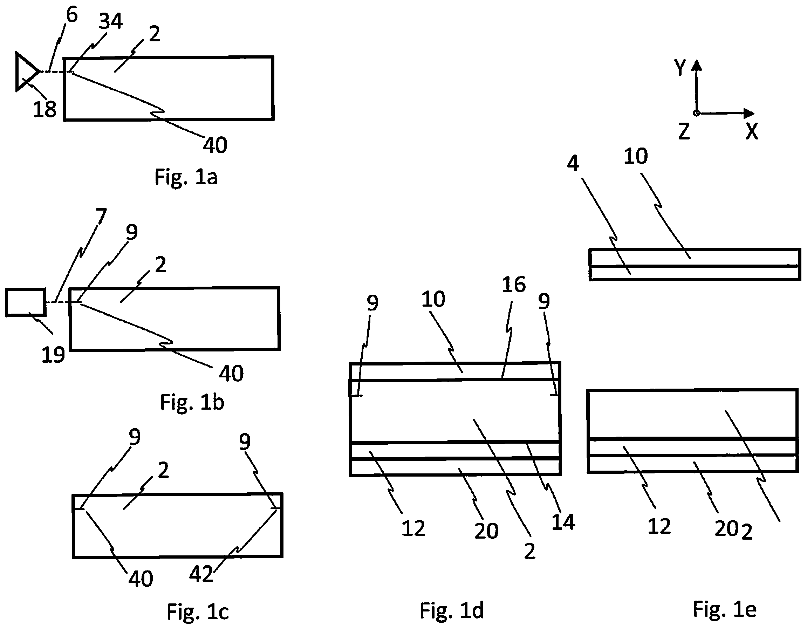

In Fig. 1a ist ein Festkörper 2 gezeigt, in den mittels einer Strahlungsquelle 18, die bevorzugt ein Laser oder eine lonenkanone ist, Defekte 34 eingebracht werden bzw. in dem Defekte 34 erzeugt werden. Die Strahlen 6 der Strahlungsquelle 18 treffen bevorzugt seitlich auf den Festkörper 2 auf und dringen in diesen ein.

In Fig. 1b ist anstelle der Strahlungsquelle 18 eine Spannungsinduziereinrichtung 19 zum Erzeugen von Spannungen in dem Festkörper 2 zum Bewirken eines Einrisses des Festkörpers 2 im Bereich der erzeugten Defekte 34 gezeigt. Die Spannungsinduziereinrichtung 19 besteht bevorzugt aus einer Erwärmungseinrichtung, insbesondere einem Laser, insbesondere einem CO2-Laser, und einer Kühlmitteleinrichtung, insbesondere zum Bereitstellen eines Kühlmittelstrahls. Mittels der Erwärmungseinrichtung, insbesondere dem Laser, wird der Bereich, in dem zuvor Defekte erzeugt wurden, erhitzt, damit Druckspannungen in diesem Bereich entstehen. Bevorzugt wird anschließend an die Erhitzung mittels der Kühlmitteleinrichtung der zunächst erhitze Bereich wieder abgekühlt, wodurch Zugspannungen in dem Bereich erzeugt werden. Die so thermisch induzierten Spannungen führen dazu, dass der Festkörper 2 im Bereich der Defekte einreist, wodurch ein Anriss 9 entsteht.

In Fig. 1c wird durch das Bezugszeichen 40 zum einen angezeigt, dass der Anriss 9 eine Rissauslösestelle darstellt. Ferner wird durch das Bezugszeichen 42 gekennzeichnet, dass der Anriss 9 zusätzlich oder alternativ auch eine Rissführung darstellen kann. Es ist hierbei somit denkbar, dass nur eine Rissführung 42 oder nur eine Rissauslösestelle 40 erzeugt wird, wobei bevorzugt beides, insbesondere zeitgleich oder zeitversetzt, erzeugt wird. Die Rissauslösestelle 40 erstreckt sich dabei in der Umfangsrichtung des Festkörpers 2 deutlich weniger als die Rissführung 42, deutlich weniger kann z.B. als genau, weniger oder mehr als 1/10, 1/100, 1/1000 der Erstreckung der Rissführung verstanden werden, wobei auch beliebige Bruchteile dazwischen denkbar sind.

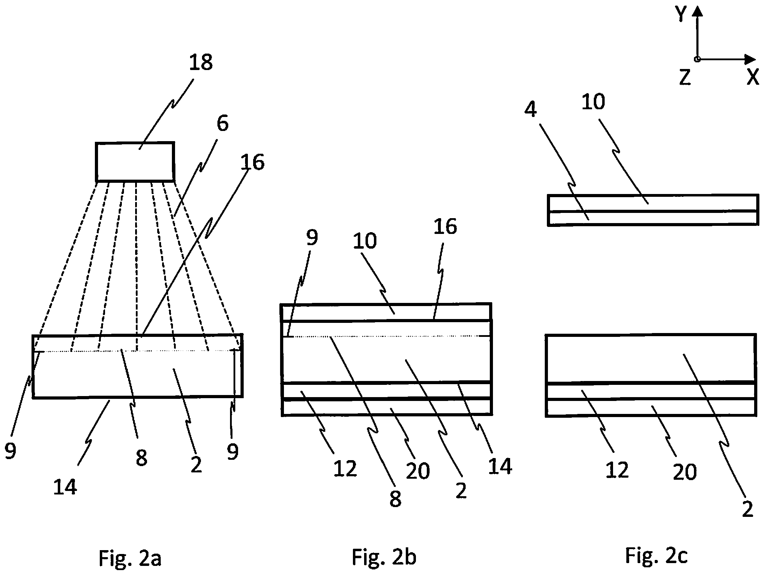

In Fig. 1d sind an dem Festkörper 2 analog zu den Ausführungen bzgl. Fig. 2b verschiedene Schichten 10, 12, 20 angeordnet. Einzelne oder alle der Schichten 10, 12, 20 werden anschließend einer thermischen Beaufschlagung ausgesetzt, durch die Spannungen in den Festkörper 2 eingeleitet werden. Aufgrund der erzeugten Anrisse 9, d.h. der Rissauslösestelle 40 und/oder der Rissführung 42, wird der Riss definiert in eine Ablöseebene eingeleitet, wodurch die Festkörperschicht 4 von dem Festkörper 2 abgetrennt wird (vgl. Fig. 1e).

Die vorliegende Erfindung bezieht sich somit auf ein Verfahren zum Herstellen von Festkörperschichten und umfasst bevorzugt die Schritte:
Bereitstellen eines Festkörpers 2 zum Abtrennen mindestens einer Festkörperschicht 4, Erzeugen von Defekten mittels mindestens einer Strahlungsquelle 18, insbesondere einem Laser, in der inneren Struktur des Festkörpers zum Vorgeben einer Rissauslösestelle, ausgehend von der die Festkörperschicht 4 vom Festkörper 2 abgetrennt wird und/oder Erzeugen von Defekten mittels mindestens der Strahlungsquelle 18, insbesondere einem Laser, in der inneren Struktur des Festkörpers 2 zum Vorgeben einer Rissführung, entlang der die Festkörperschicht 4 vom Festkörper 2 abgetrennt wird, Anordnen einer Aufnahmeschicht 10 zum Halten der Festkörperschicht 4 an dem Festkörper 2, thermisches Beaufschlagen der Aufnahmeschicht 10 zum, insbesondere mechanischen, Erzeugen von Spannungen in dem Festkörper 2, wobei sich durch die Spannungen ein Riss ausgehend von der Rissauslösestelle und/oder entlang der Rissführung in dem Festkörper 2 ausbreitet, der die Festkörperschicht 4 von dem Festkörper 2 abtrennt.

In Fig. 2a ist ein Festkörper 2 bzw. ein Substrat gezeigt, das im Bereich einer Strahlungsquelle 18, insbesondere einem Laser oder einer lonenkanone, angeordnet ist. Der Festkörper 2 weist bevorzugt einen ersten ebenen Flächenanteil 14 und einen zweiten ebenen Flächenanteil 16 auf, wobei der erste ebene Flächenanteil 14 bevorzugt im Wesentlichen oder genau parallel zu dem zweiten ebenen Flächenanteil 16 ausgerichtet ist. Der erste ebene Flächenanteil 14 und der zweite ebene Flächenanteil 16 begrenzen bevorzugt den Festkörper 2 in einer Y-Richtung, die bevorzugt vertikal bzw. lotrecht ausgerichtet ist. Die ebenen Flächenanteile 14 und 16 erstrecken sich bevorzugt jeweils in einer X-Z-Ebene, wobei die X-Z-Ebene bevorzugt horizontal ausgerichtet ist. Weiterhin lässt sich dieser Darstellung entnehmen, dass die Strahlungsquelle 18 Stahlen 6 auf den Festkörper 2 ausstrahlt. Die Strahlen 6 dringen je nach Konfiguration definiert tief in den Festkörper 2 ein und erzeugen an der jeweiligen Position bzw. an einer vorbestimmten Position einen Defekt. Durch die Defekte wird eine Schwächung bzw. Modifizierung der Festkörperstruktur bewirkt, insbesondere erfolgt eine Absenkung der Bruchfestigkeit, wobei dies auf einer Ebene bzw. im Wesentlichen oder genau auf einer Ebene erfolgt, die als Ablöseebene 8 bezeichnet wird. Die Ablöseebene 8 kann vor oder nach der Erzeugung der Rissauslösestelle 40 oder des Rissverlaufs 42 erzeugt werden. Weiterhin ist denkbar, dass die Defekte, die für die Erzeugung der Rissauslösestelle 40 und/oder der Rissführung 42 eingebracht werden, vor während oder nach der Erzeugung bzw. Einbringung der Defekte zur Erzeugung der Ablöseebene 8 erzeugt werden. Weiterhin werden die Defekte zur Erzeugung der Rissauslösestelle 40 und/oder der Rissführung 42 bevorzugt auf bzw. in der Ablöseebene 8 erzeugt.

In Fig. 2b ist eine mehrschichtige Anordnung gezeigt, wobei der Festkörper 2 die Ablöseebene 8 beinhaltet und im Bereich des ersten ebenen Flächenanteils 14 mit einer Halteschicht 12 versehen ist, die wiederum bevorzugt von einer weiteren Schicht 20 überlagert wird, wobei die weitere Schicht 20 bevorzugt eine Stabilisierungseinrichtung, insbesondere eine Metallplatte, ist. An dem zweiten ebenen Flächenanteil 16 des Festkörpers 2 ist bevorzugt eine Polymerschicht 10 angeordnet. Die Polymerschicht 10 und/oder die Halteschicht 12 bestehen bevorzugt zumindest teilweise und besonders bevorzugt vollständig aus PDMS.

In Fig. 2c ist ein Zustand nach einer Rissauslösung und anschließender Rissführung gezeigt. Die Festkörperschicht 4 haftet an der Polymerschicht 10 und ist von dem verbleibenden Rest des Festkörpers 2 beabstandet bzw. beabstandbar.

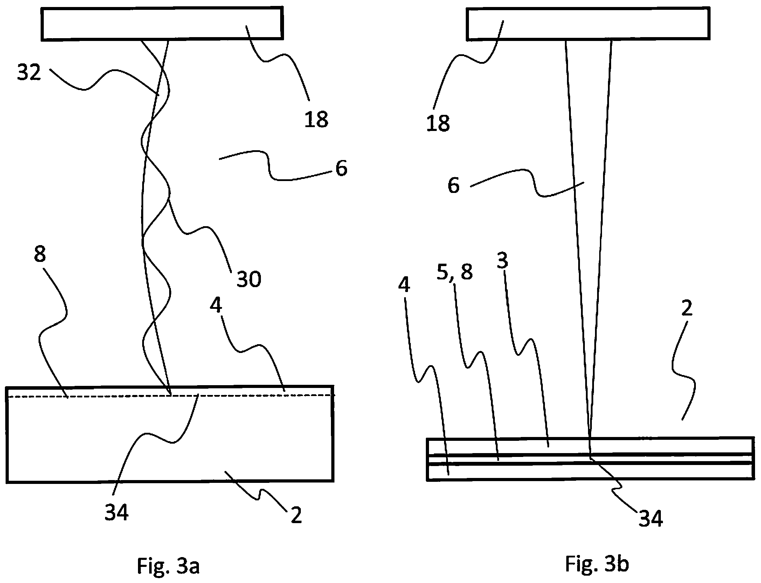

In den Figuren 3a und 3b sind Beispiele für die in Fig. 2a gezeigte Erzeugung einer Ablöseebene 8 durch die Einbringung von Defekten in einen Festkörper 2 mittels Lichtstrahlen gezeigt.

Somit ist auch ein Verfahren zum Herstellen von Festkörperschichten 4 beschrieben, das mindestens die Schritte des Bereitstellens eines Festkörpers 2 zum Abtrennen mindestens einer Festkörperschicht 4, des Erzeugens von Defekten mittels mindestens einer Strahlungsquelle, insbesondere einem Laser, in der inneren Struktur des Festkörpers zum Vorgeben einer Ablöseebene, entlang der die Festkörperschicht vom Festkörper abgetrennt wird, und des thermischen Beaufschlagens einer an dem Festkörper 2 angeordneten Polymerschicht 10 zum, insbesondere mechanischen, Erzeugen von Spannungen in dem Festkörper 2, wobei sich durch die Spannungen ein Riss in dem Festkörper 2 entlang der Ablöseebene 8 ausbreitet, der die Festkörperschicht 4 von dem Festkörper 2 abtrennt, umfasst.

In Fig. 3a ist schematisch gezeigt, wie Defekte 34 in einem Festkörper 2, insbesondere zur Erzeugung einer Ablöseebene 8 mittels einer Strahlungsquelle 18, insbesondere einem oder mehrerer Laser, erzeugbar sind. Die Strahlungsquelle 18 emittiert dabei Strahlung 6 mit einer ersten Wellenlänge 30 und einer zweiten Wellenlänge 32. Die Wellenlängen 30, 32 sind dabei derart aufeinander abgestimmt bzw. die Distanz zwischen der Strahlungsquelle 18 und der zu erzeugenden Ablöseebene 8 ist derart abgestimmt, dass die Wellen 30, 32 im Wesentlichen oder genau auf der Ablöseebene 8 in dem Festkörper 2 zusammentreffen, wodurch am Ort des Zusammentreffens 34 infolge der Energien beider Wellen 30, 32 ein Defekt erzeugt wird. Die Defekterzeugung kann dabei durch unterschiedliche oder kombinierte Zersetzungsmechanismen wie z.B. Sublimation oder chemische Reaktion erfolgen, wobei die Zersetzung dabei z.B. thermisch und/oder photochemisch initiiert werden kann.

In Fig. 3b ist ein fokussierter Lichtstrahl 6 gezeigt, dessen Brennpunkt bevorzugt in der Ablöseebene 8 liegt. Es ist hierbei denkbar, dass der Lichtstrahl 6 durch einen oder mehrere fokussierende Körper, insbesondere Linse/n (nicht gezeigt), fokussiert wird. Der Festkörper 2 ist in dieser Ausführungsform mehrschichtig ausgebildet und weist bevorzugt eine teiltransparente oder transparente Substratschicht 3 bzw. Materialschicht auf, die bevorzugt aus Saphir besteht oder Saphir aufweist. Die Lichtstrahlen 6 gelangen durch die Substratschicht 3 auf die Ablöseebene 8, die bevorzugt durch eine Opferschicht 5 gebildet wird, wobei die Opferschicht 5 durch die Strahlung derart beaufschlagt wird, dass thermisch und/oder photochemisch eine teilweise oder vollständige Zerstörung der Opferschicht 5 in dem Brennpunkt bzw. im Bereich des Brennpunkts bewirkt wird. Es ist ebenfalls denkbar, dass die Defekte zur Erzeugung der Ablöseschicht 8 im Bereich oder genau auf einer Grenzfläche zwischen zwei Schichten 3, 4 erzeugt werden. Somit ist ebenfalls denkbar, dass die Festkörperschicht 4 auf einer Trägerschicht, insbesondere einer Substratschicht 3, erzeugt wird und mittels einer oder mehrerer Opferschichten 5 und/oder mittels der Erzeugung von Defekten in einer Grenzfläche, insbesondere zwischen der Festkörperschicht 4 und der Trägerschicht, eine Ablöseebene 8 zum Ablösen bzw. Abtrennen der Festkörperschicht 4 erzeugbar ist.

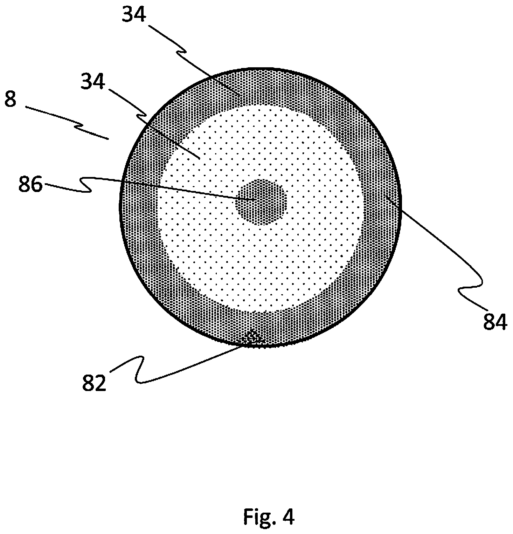

In Fig. 4 ist eine Ablöseebene 8 gezeigt, die Bereiche mit unterschiedlichen Defektkonzentrationen 82, 84, 86 aufweist. Es ist hierbei denkbar, dass eine Vielzahl an Bereichen mit unterschiedlichen Defektkonzentrationen eine Ablöseebene 8 bilden, wobei ebenfalls vorstellbar ist, dass die Defekte 34 in der Ablöseebene 8 im Wesentlichen oder genau gleichmäßig über die Fläche verteilt sind. Die unterschiedlichen Defektkonzentrationen können flächenmäßig gleich groß oder verschieden groß ausgebildet sein. Bevorzugt stellt eine erste erhöhte Defektkonzentration eine Rissauslösekonzentration 82 dar, die bevorzugt im Bereich des Randes oder sich zum Rand hin erstreckend bzw. den Rand benachbarend erzeugt wird. Zusätzlich oder alternativ kann eine Rissführungskonzentration 84 derart ausgebildet werden, dass der die Festkörperschicht 4 von dem Festkörper 2 abtrennende Riss kontrollierbar bzw. steuerbar ist. Weiterhin kann zusätzlich oder alternativ eine Zentrumskonzentration 86 erzeugt werden, die bevorzugt eine sehr ebene Oberfläche im Bereich des Zentrums des Festkörpers 2 ermöglicht. Bevorzugt ist die Rissführungskonzentration 84 teilweise oder vollständig ringförmig bzw. umschließend ausgebildet und umschließt somit bevorzugt abschnittsweise und besonders bevorzugt vollständig das Zentrum des Festkörpers 2 bzw. der Festkörperschicht 4. Es ist ferner denkbar, dass die Rissführungskonzentration 84 in einem ausgehend vom Rand des Festkörpers 2 und in Richtung Zentrum des Festkörpers 2 stufenweise oder stetig bzw. fließend abnimmt. Weiterhin ist denkbar, dass die Rissführungskonzentration 84 bandartig und homogen bzw. im Wesentlichen oder genau homogen ausgebildet ist.

### Bezugszeichenliste

- **2**: **Festkörper**
- **3**: **Substrat**
- **4**: **Festkörperschicht**
- **5**: **Opferschicht**
- **6**: **Strahlung**
- **7**: **Kühlmittel**
- **8**: **Ablöseebene**
- **9**: **Anriss**
- **10**: **Polymerschicht**
- **12**: **Halteschicht**
- **14**: **erster ebener Flächenanteil**
- **16**: **zweiter ebener Flächenanteil**
- **18**: **Strahlungsquelle**
- **19**: **Spannungsinduziereinrichtung**
- **20**: **Stabilisierungseinrichtung**
- **30**: **erster Strahlungsanteil**
- **32**: **zweiter Strahlungsanteil**
- **34**: **Ort der Defekterzeugung**
- **40**: **Rissauslösestelle**
- **42**: **Rissführung**
- **82**: **Rissauslösekonzentration**
- **84**: **Rissführungskonzentration**
- **86**: **Zentrumskonzentration**
- **X**: **erste Richtung**
- **Y**: **zweite Richtung**
- **Z**: **dritte Richtung**

## Patentansprüche

1. Verfahren zum Herstellen von Festkörperschichten, mindestens umfassend die Schritte:
Bereitstellen eines Festkörpers (2) zum Abtrennen mindestens einer Festkörperschicht (4), wobei der Festkörper (2) einen ersten ebenen Flächenanteil (14) und einen zweiten ebenen Flächenanteil (16) aufweist,
Erzeugen von Defekten (34) mittels Laserstrahlen mindestens eines Lasers in der inneren Struktur des Festkörpers (2) zum Vorgeben einer Rissführung, entlang der die Festkörperschicht (4) vom Festkörper (2) abgetrennt wird, und wobei mittels des mindestens einen Lasers oder einer weiteren Strahlungsquelle in der inneren Struktur des Festkörpers (2) weitere Defekte (34) zum Vorgeben einer Ablöseebene (8) erzeugt werden, entlang der die Festkörperschicht (4) vom Festkörper (2) abgetrennt wird,
Anordnen einer Polymerschicht (10) zum Halten der Festkörperschicht (4) an dem Festkörper (2), wobei die Polymerschicht (10) am zweiten ebenen Flächenanteil (16) angeordnet wird,
thermisches Beaufschlagen der Polymerschicht (10), wobei die thermische Beaufschlagung ein Abkühlen der Polymerschicht (10) auf eine Temperatur unter 10°C darstellt, wobei sich die Polymerschicht (10) zusammenzieht und/oder einen Glasübergang erfährt und die dabei entstehenden Kräfte auf den Festkörper (2) überträgt, wodurch in dem Festkörper (2) mechanische Spannungen erzeugt werden, und wobei sich durch die Spannungen ein Riss entlang der Rissführung in dem Festkörper (2) ausbreitet, der die Festkörperschicht (4) von dem Festkörper (2) abtrennt.

2. Verfahren nach Anspruch 1, **dadurch gekennzeichnet,**
**dass** die Bereiche des Festkörpers (2), in denen die Defekte (34) zum Vorgeben einer Rissführung erzeugt wurden, derart thermisch beaufschlagt werden, dass sich lokale Druckspannungen ergeben, wobei nach der Erzeugung der Druckspannungen eine weitere thermische Beaufschlagung zum Erzeugen von lokalen Zugspannungen erfolgt, wobei durch die unterschiedlichen thermischen Beaufschlagungen der Festkörper (2) im Bereich der Defekte (34) einreißt.

3. Verfahren nach Anspruch 2, **dadurch gekennzeichnet,**
**dass** der Festkörper (2) zum Erzeugen der Druckspannungen im Bereich der Defekte (34) mittels des mindestens einen oder eines anderen Lasers erwärmt wird und dass der Festkörper (2) zum Erzeugen der Zugspannungen mittels eines Kühlmittelstrahls abgekühlt wird.

4. Verfahren nach einem der vorangegangenen Ansprüche, **dadurch gekennzeichnet,**
**dass** der mindestens eine Laser derart konfiguriert ist, dass die von ihm ausgestrahlten Strahlen (6) die Defekte (34) an vorbestimmten Orten innerhalb des Festkörpers (2) erzeugen.

5. Verfahren nach einem der vorangegangenen Ansprüche, **dadurch gekennzeichnet,**
**dass** der Festkörper (2) an einer Halteschicht (12) zum Halten des Festkörpers (2) angeordnet wird, wobei die Halteschicht (12) an dem ersten ebenen Flächenanteil (14) des Festkörpers (2) angeordnet wird, wobei der erste ebene Flächenanteil (14) des Festkörpers (2) von dem zweiten ebenen Flächenanteil (16) des Festkörpers (2) beabstandet ist, wobei am zweiten ebenen Flächenanteil (16) die Polymerschicht (10) angeordnet wird und wobei die Ablöseebene (8) gegenüber dem ersten ebenen Flächenanteil (14) und/oder dem zweiten ebenen Flächenanteil (16) parallel ausgerichtet wird.

6. Verfahren nach einem der vorangegangenen Ansprüche, **dadurch gekennzeichnet,**
**dass** der Festkörper (2) Silizium und/oder Gallium und/oder ein keramisches Material aufweist und die Polymerschicht und/oder die Halteschicht (12) zumindest teilweise aus PDMS bestehen, wobei die Halteschicht (12) an einer zumindest abschnittsweise ebenen Fläche einer Stabilisierungseinrichtung (20) angeordnet ist, die zumindest teilweise aus mindestens einem Metall besteht.

7. Verfahren nach einem der vorangegangenen Ansprüche, **dadurch gekennzeichnet,**
**dass** die Polymerschicht (10) soweit abgekühlt wird, bis zumindest ein Teil der Polymerschicht (10) einen Glasübergang vollzieht.

## Claims

1. Process for producing solid-state body layers, at least comprising the following steps:
providing a solid-state body (2) for separation of at least one solid-state body layer (4), wherein the solid-state body (2) has a first two-dimensional area component (14) and a second two-dimensional area component (16),
creating defects (34) by means of laser beams from at least one laser in the internal structure of the solid-state body (2) in order to define a fracture line along which the solid-state body layer (4) is separated from the solid-state body (2), and wherein, by means of the at least one laser or another radiation source, further defects (34) are created in the internal structure of the solid-state body (2) in order to define a plane of detachment (8) along which the solid-state body layer (4) is separated from the solid-state body (2),
positioning a polymer layer (10) in order to retain the solid-state body layer (4) on the solid-state body (2), where the polymer layer (10) is positioned on the second two-dimensional area component (16),
subjecting the polymer layer (10) to thermal treatment, wherein the thermal treatment constitutes cooling of the polymer layer (10) to a temperature below 10°C, wherein the polymer layer (10) contracts and/or undergoes a glass transition and transmits the resultant forces to the solid-state body (2), which creates mechanical stresses in the solid-state body (2), and wherein the stresses cause a fracture to spread along the fracture line in the solid-state body (2) that separates the solid-state body layer (4) from the solid-state body (2).

2. Method according to Claim 1, **characterized in that**
the regions of the solid-state body (2) in which the defects (34) have been created in order to define a fracture line are subjected to thermal treatment so as to result in local compressive stresses, wherein the creation of the compressive stresses is followed by further thermal treatment in order to create local tensile stresses, wherein the different thermal treatments cause the solid-state body (2) to tear in the region of the defects (34).

3. Method according to Claim 2, **characterized in that**
the solid-state body (2) is heated by means of the at least one laser or another laser in order to create the compressive stresses in the region of the defects (34), and **in that** the solid-state body (2) is cooled down by means of a jet of coolant in order to create the tensile stresses.

4. Method according to any of the preceding claims,
**characterized in that**
the at least one laser is configured such that the beams (6) emitted thereby create the defects (34) at predetermined sites within the solid-state body (2).

5. Method according to any of the preceding claims,
**characterized in that**
the solid-state body (2) is positioned on a retaining layer (12) in order to retain the solid-state body (2), wherein the retaining layer (12) is positioned on the first two-dimensional area component (14) of the solid-state body (2), wherein the first two-dimensional area component (14) of the solid-state body (2) is spaced apart from the second two-dimensional area component (16) of the solid-state body (2), wherein the polymer layer (10) is positioned on the second two-dimensional area component (16) and wherein the plane of detachment (8) is aligned parallel with respect to the first two-dimensional area component (14) and/or the second two-dimensional area component (16).

6. Process according to any of the preceding claims,
**characterized in that**
the solid-state body (2) includes silicon and/or gallium and/or a ceramic material, and the polymer layer and/or the retaining layer (12) consist at least partly of PDMS, wherein the retaining layer (12) is positioned on a face of a stabilization device (20) which has at least sections that are two-dimensional and consists at least partly of at least one metal.

7. Process according to any of the preceding claims,
**characterized in that**
the polymer layer (10) is cooled until at least a portion of the polymer layer (10) undergoes a glass transition.

## Revendications

1. Procédé de production de couches de corps solide comprenant au moins les stades :
on se procure un corps (2) solide pour la séparation d'au moins une couche (4) de corps solide, dans lequel le corps (2) a une première partie (14) de surface plane et une deuxième partie (16) de surface plane,
on produit des défauts (34), au moyen du rayonnement laser d'au moins un laser, dans la structure intérieure du corps (2) solide pour la prescription d'un guide de fissuration, le long duquel on sépare la couche (4) de corps solide du corps (2) solide et dans lequel, au moyen du au moins un laser ou d'une autre source de rayonnement, on produit, dans la structure intérieure du corps (2) solide, d'autres défauts (34) pour la prescription d'un plan (8) de détachement, le long duquel on sépare la couche (4) de corps solide du corps (2) solide,
on met une couche (10) de polymère pour maintenir la couche (4) de corps solide sur le corps (2) solide, dans lequel on met la couche (10) de polymère sur la deuxième partie (16) de surface plane,
on soumet à un traitement thermique la couche (10) de polymère, le traitement thermique représentant un refroidissement de la couche (10) de polymère à une température en-dessous de 10°C, dans lequel la couche (10) de polymère se contracte et/ou subit une transition à l'état vitreux et transmet les forces, qui se créent ainsi, au corps (2) solide, grâce à quoi on produit, dans le corps (2) solide des contraintes mécaniques et dans lequel, par les contraintes, se propagent, dans le corps (2) solide, le long du guide de fissuration, une fissure, qui sépare la couche (4) de corps solide du corps (2) solide.

2. Procédé suivant la revendication 1, **caractérisé**
**en ce que** l'on traite thermiquement les parties du corps (2) solide, dans lesquelles les défauts (34) ont été produits pour prescrire un guide de fissuration, de manière à donner des contraintes de pression locales, dans lequel, après la production des contraintes de pression, on effectue un autre traitement thermique de production de contraintes de traction locales, dans lequel, par les traitements thermiques différents, le corps (2) solide se fend dans la partie des défauts (34) .

3. Procédé suivant la revendication 2, **caractérisé**
**en ce que** l'on chauffe le corps (2) solide pour la production des contraintes de pression dans la partie des défauts (34) au moyen d'un ou d'un autre laser et **en ce que** l'on refroidit le corps (2) solide pour la production des contraintes de traction au moyen d'un jet de fluide de refroidissement.

4. Procédé suivant l'une des revendications précédentes,
**caractérisé**
**en ce que** le au moins un laser est configuré de manière à ce que les rayons (6), par lui émis, produisent les défauts (34) en des emplacements déterminés à l'avance au sein du corps (2) solide.

5. Procédé suivant l'une des revendications précédentes,
**caractérisé**
**en ce que** l'on met le corps (2) solide sur une couche (12) de maintien pour le maintien du corps (2) solide, dans lequel on met la couche (12) de maintien sur la première partie (14) de surface plane du corps (2) solide, dans lequel la première partie (14) de surface plane du corps (2) solide est à distance de la deuxième partie (16) de surface plane du corps (2) solide, dans lequel on met, sur la deuxième partie (16) de surface plane, la couche (10) de polymère et dans lequel on oriente le plan (8) de détachement parallèlement à la première partie (14) de surface plane et/ou à la deuxième partie (16) de surface plane.

6. Procédé suivant l'une des revendications précédentes,
**caractérisé**
**en ce que** le corps (2) solide comporte du silicium et/ou du gallium et/ou un matériau céramique et la couche de polymère et/ou la couche (12) de maintien est constituée au moins en partie de PDMS, dans lequel la couche (12) de maintien est mise sur une surface plane au moins par endroits d'un dispositif (20) de stabilisation, qui est constitué au moins en partie d'au moins un métal.

7. Procédé suivant l'une des revendications précédentes,
**caractérisé**
**en ce que** l'on refroidit la couche (10) de polymère, jusqu'à ce qu'au moins une partie de la couche (10) de polymère passe à l'état vitreux.
